# EUROPEAN PATENT APPLICATION

(11) **EP 1 811 435 A1**
(43) Date of publication of application: **25.07.2007**
(21) Application number: 06290164.0
(22) Date of filing: 23.01.2006
(51) Int. Cl.: G06K 19/077

(54) **Electronic module suitable for identification documents and method for manfuacturing such a module**

(71) Applicant: Axalto SA, 92120 Montrouge (FR)
(72) Inventor: Vere, Dénis, Axalto SA, 92120 Montrouge (FR); Jean, Xavier, Axalto SA, 92120 Montrouge (FR); Borg, Norbert, Axalto SA, 92120 Montrouge (FR)
(74) Representative: Cassagne, Philippe M.J.

(57) **Abstract**

The invention relates to an electronic module intended to be embedded in an identification document. The module includes an antenna (21) positioned onto a flexible support layer (30) and a radio frequency micro-controller (26) affixed to said flexible support layer (30) and electrically connected to said antenna (21). The flexible support layer (30) is designed so that it can be folded up on itself along a hinge (33).

## Description

The invention relates to an electronic module intended to be inserted in identification documents such as passports, made of paper booklets, of paper or plastic card, and which contain personal data of their holder such as his/her name, birth date, address, photograph, etc. More particularly, it relates to a module, also called coil-on-module thereafter, that allows a radio frequency communication of good quality with contactless readers.

With the development of electronic identification documents, process have been implemented to include electronic devices, comprising an antenna and a radio frequency microcontroller electrically connected to said antenna, inside flexible document pages, flexible document covers, or flexible external layers in an efficient and robust way.

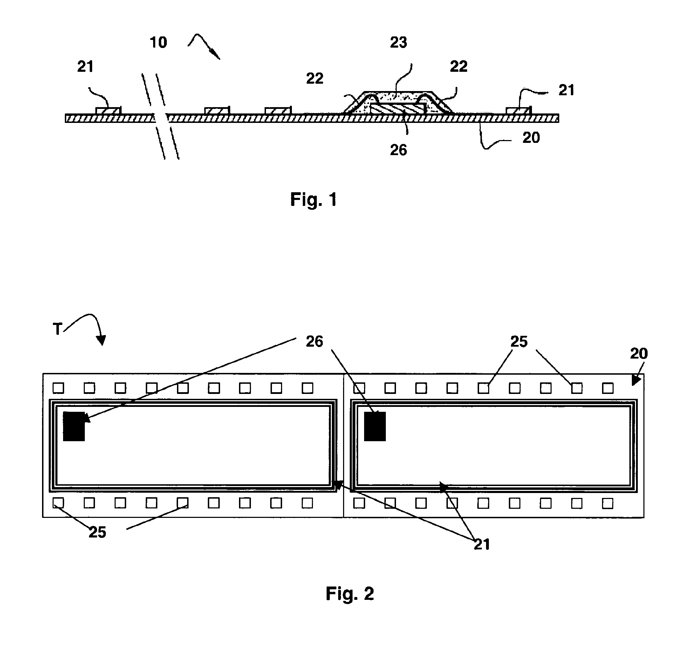

In figure 1, a prior art coil-on-module is schematically illustrated. This module is called coil-on-module because the antenna is part of the module itself and not part of a separate body like an inlet plastic sheet. The module 10 includes a flexible support layer 20. This support layer 20 is made for example of a polymer material such as epoxy glass, PET (polyethylene terephtalate), polyimide or Kapton™. Its thickness is in the range 25 - 150 µm, in order to achieve a high degree of flexibility. Using standard manufacturing techniques of the electronics printed board industry, an antenna 21 is etched onto the support layer 20. This antenna 21 has two electric pads on which a radio-frequency microcontroller 26 is connected by wire bonding 22 for example. An epoxy resin 23 is then dispatched on top of the microcontroller 26 and its bonding wires, in order to ensure their protection.

The radiofrequency microcontroller component incorporates the RFID (Radio Frequency Identification Device) technology. Therefore, it is capable of contactless communication with a reader according to communication protocols that are disclosed in the ISO-14443A and ISO-14443B standards.

The flexible support 20 of the current coil-on-modules is cut off from a tape that is usually used in smart card industries. Such a usual tape T is illustrated on figure 2. The tape T presents some indexation perforations 25 close to its longitudinal edges. These perforations are used to move the tape along the production line during the manufacture of the modules, prior to their cutting off. First, antennas 21 are etched onto the tape T and then, radio-frequency microcontrollers 26 are affixed on the tape and electrically connected to contact pads of the antennas by conventional process. Radio-frequency microcontrollers are then coated in a resin in order to be protected against mechanical strains. The thus obtained electronic coil-on-modules are finally cut off from the tape T and embedded in identification documents, such as passport, made of paperboard or paper booklet, of plastic or paper for example. Typically, tapes T that are usually used in smart cards industry have a width of 35 mm, in order to be embedded in plastic smart card that have standardized dimensions defined by ISO-7810 and ISO-7816 standards.

The antennas, which are etched onto this tape, have a rectangular shape with dimensions which are roughly 80 mm length and 30 mm wide. Typically, the width of the antennas is limited by the width of the tape used. Consequently, the dimensions of these antennas are suitable for smart cards.

However, in the case of the identification documents applications, such as electronic passport applications, chips that are designed for larger antennas don't have good behaviour on the antennas that are etched onto the tape T because these antennas are too much small, so that they affect the performance of the communication and the interoperability.

Moreover, for reasons of interoperability with a wide range of contactless readers, national authorities of many countries recommend to use antenna of class 1 for the electronic module that must be embedded in identification documents. Antenna of class 1, whose specifications are defined in IEEE 802.16 standard, must have dimensions which are at least 64 mm length x 34 mm wide and at the maximum of 81 mm length x 49 mm wide. Such antenna of class 1 is also of low cost, so that it allows advantageously a mass production of low cost passports or other identification documents for general public.

Therefore, it is necessary to increase the shape of the antenna of the coil-on-modules that are intended for identification documents such as electronic passport.

Nevertheless, the transformation of the antenna shape should not involve over cost. Consequently, it is important not to change all the machines that are used in smart card plants.

Considering the above, a first problem intended to be solved by the invention is to develop an electronic module adapted for being embedded in an identification document, said electronic module including an antenna positioned onto a flexible support layer and a radio frequency micro-controller affixed to said flexible support layer and electrically connected to said antenna, said antenna having an increased surface to allow an improved radio frequency communication with wide range of contactless readers, and said radio frequency micro controller being affixed and electrically connected with the same tools as usually used.

The solution of the invention to this problem relates to the fact that the flexible support layer is designed so that it can be folded up on itself along a hinge.

Thus, the flexible support being folded up on itself during the affixing and the connexion of the radiofrequency microcontroller, it allows to use the same tools as usually used in smart card industry. Moreover, the flexible support layer is larger than those usually used so that it allows to have an antenna with an increased surface. The thus increased surface of the antenna allows good communications radio frequency with contactless readers.

Another problem intended to be solved by the invention is to develop a method for manufacturing an electronic module, said method comprising the steps of positioning an antenna on a flexible support layer, affixing a radio-frequency micro-controller onto said flexible support layer and electrically connecting the micro-controller to said antenna, said method allowing to make an antenna having a shape that does not affect the radio frequency communication with contactless readers.

The solution of the invention to this problem consists, before the affixing of the radiofrequency microcontroller, in
- providing at least one aperture which is located with a symmetrical place of the radiofrequency microcontroller compared to an axis of symmetry formed by a hinge when the flexible support layer is folded up on itself, and
- folding up the flexible support layer on itself.

Thus, the process has the advantage that a larger flexible support can be processed on a usual machine that is used in smart card plants. Moreover, with such a larger flexible support, the surface of the etched antenna is increased, so that performances of communication are better and form factor is more compliant with a large shape of reader antenna.

The invention relates also to a tape comprising etched antennas , said tape being able to be folded up on itself along a hinge during the affixing and the connexion of radiofrequency microcontrollers to antennas, said tape including for that at least apertures that are located with a symmetrical place of the radiofrequency microcontrollers compared to an axis of symmetry formed by the hinge.

Finally, the invention relates also to a method for manufacturing an electronic identification document, which includes an electronic module that allows an improved radiofrequency communication with wide range of contactless readers. For that, this method comprises the steps of :
- providing a flexible support layer,
- positioning antenna onto said flexible support layer,
- providing at least one aperture in said flexible support layer, that is located with a symmetrical place of a radio frequency microcontroller compared to an axis of symmetry formed by a hinge when the flexible support layer is folded up on itself,
- folding up the flexible support layer on itself along a hinge,
- affixing a radiofrequency microcontroller,
- electrically connecting the radio frequency microcontroller to the antenna,
- unfolding the flexible support layer of a thus obtained electronic module in order to increase the surface of its antenna,
- embedding the thus obtained electronic module between at least two sheets of an identification document.

For a better understanding of the present invention, reference will now be made, by way of example, to the following description of the invention and to the accompanying drawings, in which:
- figure 1, already described, is a schematic cross-section illustrating a coil-on-module according to the prior art;
- figure 2, already described, is a schematic front view of a tape usually used in the smart card industry;
- figures 3A and 3B, are schematic front views of coil-on-modules according to the present invention,
- figure 4, is a schematic view of the coil-on-module of figures 3A and 3B embedded in an electronic identification document.

Corresponding numerals and symbols in the figures refer to corresponding parts, unless otherwise indicated.

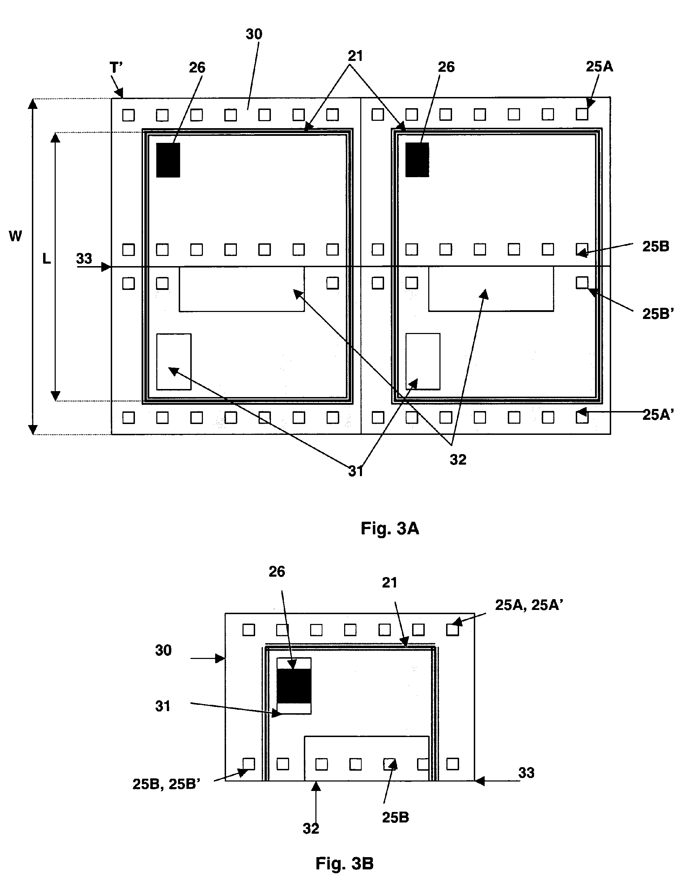

In a preferred embodiment illustrated by figures 3A and 3B, the tape T' used is larger than those usually used in smart card industry. In fact, it is twice broader than those usually used. The tape T' has consequently a width W of 70 mm. Thus, for being processed on usual machines, the tape T' must be able to be folded up on itself along a hinge 33.

When each coil-on-module is cut off from the tape T', after affixing and electrically connecting the radiofrequency microcontrollers 26 on antennas 21, then the tape T' forms a flexible support layer 30.

With such flexible support layer, antenna 21 that is etched can have a maximum length L of 65 mm, the coil being rotated of 90° compared to usually. Preferably, the coils of each antenna are positioned close to the edges of the flexible support layer 30.

The flexible support layer 30 comprises indexation perforations 25A, 25B on a first half along its longitudinal edges, and other symmetrical perforations 25A' and 25B', compared to an axis of symmetry formed by the hinge 33, on a second half. These perforations allow the machine tool to grip the tape T' in order to move it during the manufacture of the modules, prior to their cutting off.

Furthermore, in order to be able to affix the radiofrequency microcontroller and to electrically connecting it to the antenna when the flexible support layer 30 is folded up on itself, at least one aperture 31 is cut out in the flexible support layer 30, in a symmetrical place with that of the radiofrequency microcontroller 26 compared to the hinge 33.

When the flexible support layer 30 is folded up on itself, the indexation perforations 25B and 25B' that are located near the hinge 33, and on both sides of the hinge 33, are superimposed. However, there is a risk that these perforations do not superimpose well the ones with the others. In this case, the tape T', from which the flexible support of each module is cut off, is not well griped and moved along the production line. For this reason, it is preferable to provide at least another aperture 32 located at place of some indexation perforations close to the hinge 33. This aperture may be located indifferently around some indexation perforations 25B or around some symmetrical indexation perforations 25B'. With this large aperture 32, one can be sure that the tape T' is well moved because only the indexation perforations 25B (on figures 3A and 3B) on one side of the hinge 33 are griped by the machine tool.

Figure 3B illustrates a thus obtained coil-on-module after having cut it off from the tape T'. As illustrated, the tape T' thus forming the flexible support layer 30 of the module is folded up on itself.

The thus obtained coil-on-module can then be unfolded along the hinge 33 and inserted in all types of identification documents, such as passport.

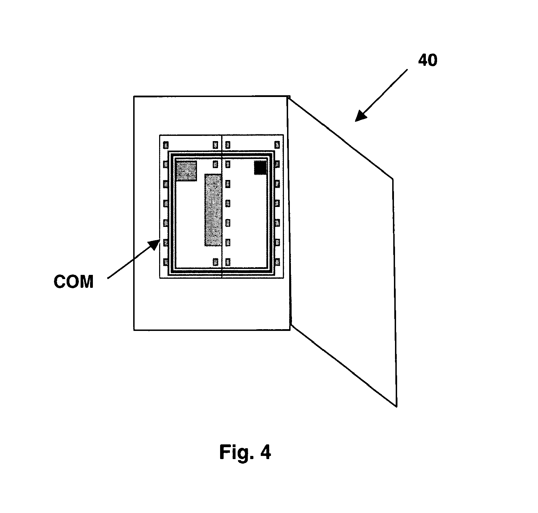

Figure 4 schematically illustrates the embedding of the coil-on-module COM in the cover or the internal page of an electronic passport 40, made of paper booklet for example. The unfolded coil-on-module is laminated between at least two flexible layers so that it is invisible in the eye.

The thus described electronic coil-on-module and its manufacturing process bring a lot of advantages. Among these advantages, the radio frequency micro-controller is affixed on the flexible support layer with the same tools as usually, because the tape used is folded up on itself in order to have the same width as that one of the usual tape. On final devices such as passport or other electronic documents, the flexible support of the coil-on-module is unfolded to offer a larger antenna surface for a better electromagnetic coupling and a better behaviour with a wide range of contactless readers, and to be class 1 compliant.

Moreover, the aperture 32 defined in the flexible support 30 of the coil-on-module around some indexation perforations 25B' confers a great advantage for securely embedding the coil-on-module between two sheets of an identification document. Namely, the glue used during the lamination process fills the opening 32, so that it become impossible to pull out the module from the identification document by delamination of the sheets, without destroying the module.

## Claims

1. Electronic module adapted to be embedded in an identification document, said electronic module including an antenna (21) positioned onto a flexible support layer (30) and a radio frequency micro-controller (26) affixed to said flexible support layer (30) and electrically connected to said antenna (21), wherein said flexible support layer (30) is designed so that it can be folded up on itself along a hinge (33).

2. Electronic module of claim 1, wherein said flexible support layer comprises at least one aperture (31) which is located with a symmetrical place of the radio frequency microcontroller (26) compared to an axis of symmetry formed by the hinge (33).

3. Electronic module of claim 1 or 2, wherein coils of the antenna (21) are positioned close to the edges of the flexible support layer (30).

4. Electronic module of anyone of previous claims, wherein the width of the flexible support (30) is of 70 mm.

5. Electronic module of anyone of previous claims, wherein the antenna (21) is class 1 compliant.

6. Electronic module of anyone of previous claims, wherein the length of the antenna (21) is at the maximum 65 mm.

7. Electronic module of anyone of previous claims, wherein the flexible support layer (30) comprises other aperture(s) located at place of indexation perforations (25b, 25B') close to the hinge (33).

8. Identification document (40) comprising an electronic module (COM) of anyone of previous claims 1 to 7, said electronic module being embedded between at least two flexible sheets.

9. Method for manufacturing an electronic module, said method comprising the steps of positioning an antenna (21) on a flexible support layer (30), affixing a radio-frequency micro-controller (26) onto said flexible support layer (30), and electrically connecting the micro-controller (26) to said antenna (21), wherein said method further comprises the steps of :
before the affixing of the radiofrequency microcontroller,
- providing at least one aperture (31) which is located with a symmetrical place of the radio frequency microcontroller (26) compared to an axis of symmetry formed by a hinge (33) when the flexible support layer (30) is folded up on itself, and
- folding up the flexible support layer (30) on itself.

10. Method of claim 9, comprising another step of providing other aperture(s) (32) located at place of indexation perforations (25B, 25B') close to the hinge (33).

11. A tape (T') comprising etched antennas (21), said tape being able to be folded up on itself along a hinge (33) during the affixing and the connexion of microcontrollers (26) to antennas (21), said tape including for that at least apertures (31) that are located with a symmetrical place of the radio frequency microcontrollers (26) compared to an axis of symmetry formed by the hinge (33).

12. Method for manufacturing an electronic identification document, said method comprising the steps of :
- providing a flexible support layer (30),
- positioning antenna (21) onto said flexible support layer (30),
- providing at least one aperture (31) in said flexible support layer (30), that is located with a symmetrical place of a radio-frequency microcontroller (26) compared to an axis of symmetry formed by a hinge (33) when the flexible support layer (30) is folded up on itself,
- folding up the flexible support layer (30) on itself along a hinge (33),
- affixing a radiofrequency microcontroller (26),
- electrically connecting the radio frequency microcontroller (26) to said antenna (21),
- unfolding the flexible support layer(30) of a thus obtained electronic module in order to increase the surface of its antenna (21),
- embedding the thus obtained electronic module between at least two sheets of an identification document (40).
